# EUROPEAN PATENT APPLICATION

(11) **EP 4 614 568 A1**
(43) Date of publication of application: **10.09.2025**
(21) Application number: 24814126.9
(22) Date of filing: 08.05.2024
(51) Int. Cl.: H01L 23/528, H01L 23/538, H01L 25/065, H10B 80/00, H01L 23/50

(54) **SEMICONDUCTOR CHIP, SEMICONDUCTOR STRUCTURE AND SEMICONDUCTOR DEVICE**

(30) Priority: 26.05.2023 CN 202310621163
(71) Applicant: CXMT Corporation, Hefei City, Anhui Province 230601 (CN)
(72) Inventor: ZHANG, Jiarui, Hefei, Anhui 230601 (CN)
(74) Representative: Gulde & Partner
(86) International application number: PCT/CN2024/091608
(87) International publication number: WO 2024/244923

(57) **Abstract**

Embodiment of the present disclosure discloses a semiconductor chip, a semiconductor structure, and a semiconductor device. The semiconductor chip includes: a first ID transmission path, penetrating through a substrate of the semiconductor chip in a direction perpendicular to an active surface of the semiconductor chip; a second ID transmission channel, penetrating through the substrate in the direction perpendicular to the active surface of the semiconductor chip, and symmetrically distributed with the first ID transmission path based on a central axis of the semiconductor chip, where the central axis passes through a center of the semiconductor chip and is parallel to the active surface; and an ID decoding circuit, coupled to the first ID transmission path or the second ID transmission path, where the ID decoding circuit is configured to receive an ID signal and decode the ID signal to generate a data selection signal, where the semiconductor chip outputs data signals transmitted in a plurality of data transmission paths to corresponding internal receiving circuits respectively according to the data selection signal.

## Description

The present disclosure claims priority to Chinese Patent Application No. 202310621163.0 filed with China National Intellectual Property Administration on May 26, 2023 and entitled "SEMICONDUCTOR CHIP, SEMICONDUCTOR STRUCTURE, AND SEMICONDUCTOR DEVICE", the content of which is incorporated herein by reference in its entirety.

### TECHNICAL FIELD

Embodiments of the present disclosure relate to the technical field of semiconductors, and in particular, to a semiconductor chip, a semiconductor structure, and a semiconductor device.

### BACKGROUND

As the demand for electronic products moves towards miniaturization and multifunctionality, packaging technology is also developing towards high density and high integration. For example, at least two memory chips (dies) are three-dimensionally stacked and packaged in a direction perpendicular to a horizontal plane.

However, the three-dimensional stack structure still faces many technical problems to be solved, for example, how to ensure that data is accurately transmitted to each chip of the three-dimensional stack structure.

### SUMMARY

According to a first aspect of embodiments of the present disclosure, provided is a semiconductor chip. The semiconductor chip includes:
a first identification (ID) transmission path, penetrating through a substrate of the semiconductor chip in a direction perpendicular to an active surface of the semiconductor chip;
a second ID transmission path, penetrating through the substrate in the direction perpendicular to the active surface of the semiconductor chip, and symmetrically distributed with the first ID transmission path based on a central axis of the semiconductor chip, where the central axis passes through a center of the semiconductor chip and is parallel to the active surface; and
an ID decoding circuit, coupled to the first ID transmission path or the second ID transmission path, where the ID decoding circuit is configured to receive an ID signal and decode the ID signal to generate a data selection signal,
where the semiconductor chip outputs data signals transmitted in a plurality of data transmission paths to corresponding internal receiving circuits respectively according to the data selection signal.

In some embodiments, each of the internal receiving circuits includes: a first data receiving circuit and a second data receiving circuit, where the first data receiving circuit is coupled to a first data selecting circuit, and the second data receiving circuit is coupled to a second data selecting circuit;
and the plurality of data transmission paths include:
a first data transmission path, penetrating through the substrate in the direction perpendicular to the active surface of the semiconductor chip, where the first data transmission path is configured to transmit a first data signal;
a second data transmission path, penetrating through the substrate in the direction perpendicular to the active surface of the semiconductor chip, and symmetrically distributed with the first data transmission path based on the central axis, where the second data transmission path is configured to transmit a second data signal, and the second data signal is different from the first data signal;
the first data selecting circuit, separately coupled to the ID decoding circuit, the first data transmission path, and the second data transmission path, where the first data selecting circuit is configured to output one of the first data signal or the second data signal to the first data receiving circuit according to the data selection signal; and
the second data selecting circuit, separately coupled to the ID decoding circuit, the first data transmission path, and the second data transmission path, where the second data selecting circuit is configured to output the other of the first data signal or the second data signal to the second data receiving circuit according to the data selection signal.

In some embodiments, the first ID transmission path is configured to transmit a first ID signal; and
the second ID transmission path is configured to transmit a second ID signal, where the second ID signal is different from the first ID signal.

In some embodiments, the first ID transmission path includes: a first connection pad located on an inactive face of the semiconductor chip, a first path located in the substrate, and a first interconnection structure located on the active surface of the semiconductor chip, where the first connection pad, the first path, and the first interconnection structure are sequentially connected; and
the second ID transmission path includes: a second connection pad located on the inactive face of the semiconductor chip, a second path located in the substrate, and a second interconnection structure located on the active surface of the semiconductor chip, where the second connection pad, the second path, and the second interconnection structure are sequentially connected.

In some embodiments, the ID decoding circuit is coupled to the first interconnection structure or the second interconnection structure.

According to a second aspect of the embodiments of the present disclosure, provided is a semiconductor structure. The semiconductor structure includes:
a logic chip; and
a stack structure,
stacked on the logic chip, and including: 1st to 2N-th semiconductor chips stacked sequentially, where the 1st to 2N-th semiconductor chips are same memory chips; an inactive face of the 1st semiconductor chip is bonded to the logic chip, and an active surface of a 2i-th semiconductor chip is bonded to an active surface of a 2i-1-th semiconductor chip; and N is a positive integer, and i is a positive integer less than or equal to N; and where
each of the semiconductor chips includes: a first ID transmission path, a second ID transmission path, and an ID decoding circuit; the first ID transmission path and the second ID transmission path penetrate through a substrate of one of the semiconductor chips in a direction perpendicular to an active surface of the corresponding one of the semiconductor chips and are symmetrically distributed based on a central axis of the corresponding one of the semiconductor chips, and the central axis passes through a center of the corresponding one of the semiconductor chips and is parallel to the active surface; and the ID decoding circuit is coupled to the first ID transmission path or the second ID transmission path, the ID decoding circuit is configured to receive an ID signal, and the ID signal indicates that one of the semiconductor chips is the 2i-th semiconductor chip or the 2i-1-th semiconductor chip in the stack structure,
where the first ID transmission path of the 2i-1-th semiconductor chip and the second ID transmission path of the 2i-th semiconductor chip are sequentially connected to form a first ID transmission channel; and the second ID transmission path of the 2i-1-th semiconductor chip and the first ID transmission path of the 2i-th semiconductor chip are sequentially connected to form a second ID transmission channel.

In some embodiments, the logic chip is configured to:
output a first ID signal to the ID decoding circuit of the 2i-1-th semiconductor chip through one of the first ID transmission channel and the second ID transmission channel; and
output a second ID signal to the ID decoding circuit of the 2i-th semiconductor chip through the other of the first ID transmission channel and the second ID transmission channel, where the second ID signal is different from the first ID signal.

In some embodiments, the ID decoding circuit is configured to: decode the first ID signal to generate a first data selection signal, or decode the second ID signal to generate a second data selection signal,
where the second data selection signal is different from the first data selection signal.

In some embodiments, each of the semiconductor chips further includes: a first data receiving circuit, a second data receiving circuit, a first data transmission path, a second data transmission path, a first data selecting circuit, and a second data selecting circuit, where the first data transmission path and the second data transmission path penetrate through the substrate in a direction perpendicular to an active surface of one of the semiconductor chips and are symmetrically distributed based on the central axis;
the first data selecting circuit is separately coupled to the ID decoding circuit, the first data transmission path, the second data transmission path, and the first data receiving circuit; and
the second data selecting circuit is separately coupled to the ID decoding circuit, the first data transmission path, the second data transmission path, and the second data receiving circuit; and
where the first data transmission path of the 2i-1-th semiconductor chip and the second data transmission path of the 2i-th semiconductor chip are sequentially connected to form a first data transmission channel; the second data transmission path of the 2i-1-th semiconductor chip and the first data transmission path of the 2i-th semiconductor chip are sequentially connected to form a second data transmission channel; the first data transmission channel is configured to transmit a first data signal; the second data transmission channel is configured to transmit a second data signal; and the second data signal is different from the first data signal.

In some embodiments, the first data selecting circuit of the 2i-1-th semiconductor chip is configured to: output one of the first data signal and the second data signal to the first data receiving circuit of the 2i-1-th semiconductor chip according to the first data selection signal;
the second data selecting circuit of the 2i-1-th semiconductor chip is configured to: output the other of the first data signal and the second data signal to the second data receiving circuit of the 2i-1-th semiconductor chip according to the first data selection signal;
the first data selecting circuit of the 2i-th semiconductor chip is configured to: output one of the first data signal and the second data signal to the first data receiving circuit of the 2i-th semiconductor chip according to the second data selection signal; and
the second data selecting circuit of the 2i-th semiconductor chip is configured to: output the other of the first data signal and the second data signal to the second data receiving circuit of the 2i-th semiconductor chip according to the second data selection signal.

In some embodiments, central axes of any two adjacent semiconductor chips among the 1st to 2N-th semiconductor chips are aligned, where the first ID transmission path of one of the two adjacent semiconductor chips is aligned with the second ID transmission path of the other of the two adjacent semiconductor chips.

In some embodiments, an inactive face of a 2j-th semiconductor chip is bonded to an inactive face of a 2j+1-th semiconductor chip, where j is an integer greater than or equal to one, and 2j+1 is less than 2N.

In some embodiments, the first ID transmission path includes: a first connection pad located on an inactive face of the semiconductor chip, a first path located in the substrate, and a first interconnection structure located on the active surface of the semiconductor chip, where the first connection pad, the first path, and the first interconnection structure are sequentially connected; and
the second ID transmission path includes: a second connection pad located on an inactive face of one of the semiconductor chips, a second path located in the substrate, and a second interconnection structure located on an active surface of the corresponding one of the semiconductor chips, where the second connection pad, the second path, and the second interconnection structure are sequentially connected.

According to a third aspect of the embodiments of the present disclosure, provided is a semiconductor device. The semiconductor device includes:
a substrate,
where the semiconductor chip according to any embodiment of the first aspect of the embodiments of the present disclosure is located on the substrate, and the semiconductor chip is bonded to the substrate; or, the semiconductor structure according to any embodiment of the second aspect of the embodiments of the present disclosure is located on the substrate, and the semiconductor structure is bonded to the substrate.

In some embodiments, the semiconductor device includes: a high bandwidth memory.

In the embodiments of the present disclosure, by coupling the ID decoding circuit to the first ID transmission path or the second ID transmission path, the ID decoding circuit may generate the data selection signal according to the ID signal transmitted in the first ID transmission path or the second ID transmission path, and the internal receiving circuit may receive the data signal transmitted in one of the plurality of data transmission paths according to the data selection signal, thereby ensuring that the data is accurately transmitted to the corresponding internal receiving circuit in the semiconductor chip.

In addition, the first ID transmission path and the second ID transmission path are symmetrically distributed based on the central axis of the semiconductor chip; when a plurality of semiconductor chips are stacked to form a three-dimensional stack structure, the ID signals transmitted in the first ID transmission path and the second ID transmission path may generate an odd flag bit/even flag bit in each semiconductor chip, such that the complexity of assigning the stack ID is reduced, and meanwhile, it can also ensure that the data is separately and accurately transmitted to each chip of the three-dimensional stack structure through the same transmission paths.

### BRIEF DESCRIPTION OF THE DRAWINGS

FIG. 1 is a schematic view of a three-dimensional stack structure according to an exemplary embodiment;
FIG. 2 is a cross-sectional view of a semiconductor chip according to an embodiment of the present disclosure;
FIG. 3 is a top view of a semiconductor chip according to an embodiment of the present disclosure;
FIG. 4 is a schematic view of a semiconductor chip according to an embodiment of the present disclosure;
FIG. 5 is a cross-sectional view of a semiconductor structure according to an embodiment of the present disclosure; and
FIGS. 6A and 6B are top views of a semiconductor chip according to an embodiment of the present disclosure.

### DETAILED DESCRIPTION

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. The advantages and features of the present disclosure will become apparent from the following description and claims. It should be noted that the drawings are all in a very simplified form and not to a precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between the top surface and the bottom surface of a continuous structure, or a layer may be located between any pair of horizontal planes at the top surface and the bottom surface of the continuous structure. A layer may extend horizontally, perpendicularly, and/or along inclined surfaces. A layer may include a plurality of sub-layers.

It should be noted that unless conflicting, the technical solutions described in the embodiments of the present disclosure may be arbitrarily combined.

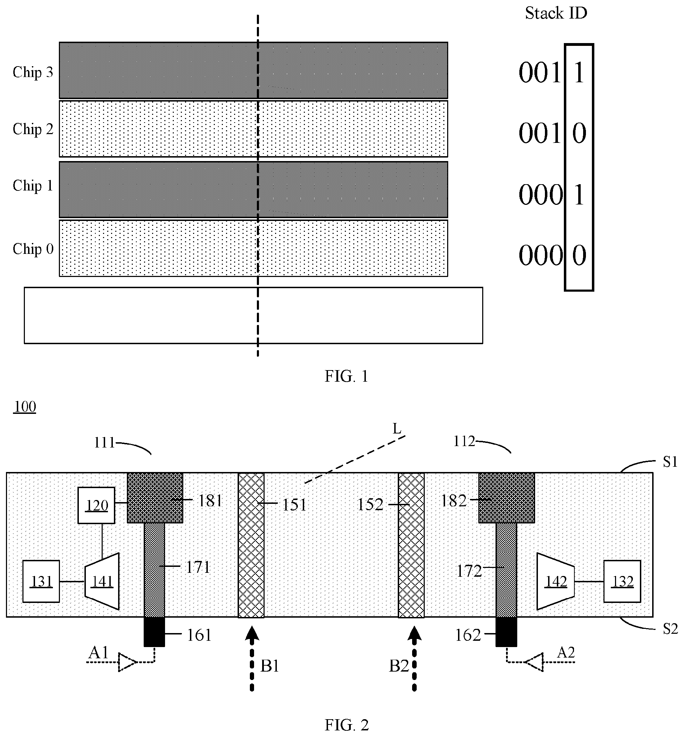

FIG. 1 is a schematic view of a three-dimensional stack structure according to an exemplary embodiment. Referring to FIG. 1, the stack structure includes a plurality of chips, e.g., chip 0, chip 1, chip 2, and chip 3, sequentially stacked on a logic chip. Here, four chips are merely examples to convey the present disclosure to those skilled in the art, and the number of the chip in the stack structure is not limited to four, but may be 8, 16, or more, which is not particularly limited in the present disclosure.

By assigning stack IDs to a plurality of chips, respectively, as shown in FIG. 1, an odd/even flag bit can be generated in each chip. The odd/even flag bit serves as a circuit direction switch to accurately transmit data to each chip. However, this method of assigning stack IDs is complicated.

In view of this, the embodiment of the present disclosure provides a semiconductor chip, a semiconductor structure, and a semiconductor device.

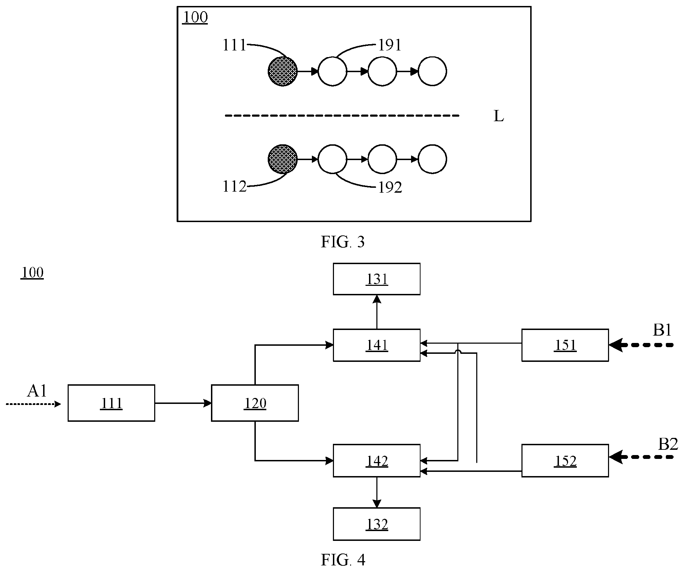

FIG. 2 is a schematic cross-sectional view of a semiconductor chip 100 according to an embodiment of the present disclosure, FIG. 3 is a top view of the semiconductor chip 100 according to an embodiment of the present disclosure, and FIG. 4 is a schematic view of the semiconductor chip 100 according to an embodiment of the present disclosure. The semiconductor chip 100 provided according to an embodiment of the present disclosure will be described in detail with reference to FIGS. 2, 3, and 4.

Referring to FIGS. 2 to 4, the semiconductor chip 100 includes a first ID transmission path 111, a second ID transmission path 112, and an ID decoding circuit 120. The first ID transmission path 111 and the second ID transmission path 112 penetrate through a substrate in a direction perpendicular to the active surface S1 of the semiconductor chip 100 and are symmetrically distributed based on the central axis L of the semiconductor chip 100. The ID decoding circuit 120 is coupled to the first ID transmission path 111 or the second ID transmission path 112, and the ID decoding circuit 120 is configured to receive an ID signal and decode the ID signal to generate a data selection signal. The semiconductor chip 100 outputs data signals transmitted in a plurality of data transmission paths to the corresponding internal receiving circuits respectively according to the data selection signal. It should be noted that the central axis is an axis passing through the center of the semiconductor chip and parallel to the active surface S1 (or an inactive face S2), and is represented by a dotted line L in the present disclosure, as shown in FIG. 2 or 3.

The semiconductor chip 100 includes a front surface provided with a peripheral circuit and a memory cell array and a back surface opposite to the front surface. The front surface of the semiconductor chip 100 is denoted as the active surface S1, and the back surface of the semiconductor chip 100 is denoted as the inactive face S2, as shown in FIG. 2. The semiconductor chip 100 may be a dynamic random access memory (dynamic random access memory, DRAM) chip, or may be at least one of a static random access memory (static random access memory, SRAM) chip, a NOR flash memory chip, and a NAND flash memory chip. The embodiment of the present disclosure is not particularly limited to the type of the semiconductor chip 100.

The first ID transmission path 111 and the second ID transmission path 112 are used to transmit ID signals. For example, the first ID transmission path 111 is configured to transmit a first ID signal A1, the second ID transmission path 112 is configured to transmit a second ID signal A2, and the second ID signal A2 is different from the first ID signal A1.

It will be understood that when a plurality of semiconductor chips 100 are three-dimensionally stacked and packaged in a direction perpendicular to the horizontal plane, the ID signals transmitted in the first ID transmission path 111 and the second ID transmission path 112 may generate an odd flag bit/even flag bit in each semiconductor chip 100. The odd flag bit or the even flag bit may serve as a switching ID of a transmission path between data and a circuit, thereby ensuring that the data is accurately transmitted to the corresponding internal receiving circuit in each chip.

In a specific embodiment, the ID signal may be represented by a binary signal "0" or "1". For example, the ID signal "0" is configured to indicate that the semiconductor chip 100 is an even chip in the stack structure, and the ID signal "1" is configured to indicate that the semiconductor chip 100 is an odd chip in the stack structure. For another example, the ID signal "0" is configured to indicate that the semiconductor chip 100 is an odd chip in the stack structure, and the ID signal "1" is configured to indicate that the semiconductor chip 100 is an even chip in the stack structure.

The ID decoding circuit is used for decoding the ID signal and generating a data selection signal. For example, the ID decoding circuit 120 is coupled to the first ID transmission path 111, and the ID decoding circuit 120 is configured to receive the first ID signal A1 transmitted in the first ID transmission path 111 and decode the first ID signal A1 to generate the data selection signal. As another example, the ID decoding circuit 120 is coupled to the second ID transmission path 112, and the ID decoding circuit 120 is configured to receive the second ID signal A2 transmitted in the second ID transmission path 112 and decode the second ID signal A2 to generate the data selection signal.

It should be noted that since the second ID signal A2 is different from the first ID signal A1, the data selection signal generated by decoding the first ID signal is different from the data selection signal generated by decoding the second ID signal in the embodiment. In other embodiments, when the second ID signal is the same as the first ID signal, the data selection signal generated by decoding the first ID signal may be the same as the data selection signal generated by decoding the second ID signal.

The semiconductor chip 100 includes a plurality of data transmission paths and a plurality of internal receiving circuits. Each internal receiving circuit is separately coupled to the plurality of data transmission paths, and each internal receiving circuit may receive the data signal transmitted in one of the plurality of data transmission paths according to the data selection signal. Here, the number of the data transmission path may be two or more, and the number of the internal receiving circuit may be two or more, which is not particularly limited in the present disclosure.

In the embodiments of the present disclosure, by coupling the ID decoding circuit to the first ID transmission path or the second ID transmission path, the ID decoding circuit may generate the data selection signal according to the ID signal transmitted in the first ID transmission path or the second ID transmission path, and the internal receiving circuit may receive the data signal transmitted in one of the plurality of data transmission paths according to the data selection signal, thereby ensuring that the data is accurately transmitted to the corresponding internal receiving circuit in the semiconductor chip.

In addition, the first ID transmission path and the second ID transmission path are symmetrically distributed based on the central axis of the semiconductor chip; when a plurality of semiconductor chips are stacked to form a three-dimensional stack structure, the ID signals transmitted in the first ID transmission path and the second ID transmission path may generate an odd flag bit/even flag bit in each semiconductor chip, such that the complexity of assigning the stack ID is reduced, and meanwhile, it can also ensure that the data is separately and accurately transmitted to each chip of the three-dimensional stack structure through the same transmission paths.

In some embodiments, with reference to FIGS. 2 and 4, the internal receiving circuit includes: a first data receiving circuit 131 and a second data receiving circuit 132. The first data receiving circuit 131 is coupled to a first data selecting circuit 141; the second data receiving circuit 132 is coupled to a second data selecting circuit 142.

The plurality of data transmission paths include:
a first data transmission path 151, penetrating through the substrate in the direction perpendicular to the active surface S1 of the semiconductor chip 100, where the first data transmission path 151 is configured to transmit a first data signal B1;
a second data transmission path 152, penetrating through the substrate in the direction perpendicular to the active surface S1 of the semiconductor chip 100, and symmetrically distributed with the first data transmission path 151 based on the central axis L, where the second data transmission path 152 is configured to transmit a second data signal B2; the second data signal B2 is different from the first data signal B1;
a first data selecting circuit 141, separately coupled to the ID decoding circuit 120, the first data transmission path 151, and the second data transmission path 152, where the first data selecting circuit 141 is configured to output one of the first data signal B1 or the second data signal B2 to the first data receiving circuit 131 according to the data selection signal; and
a second data selecting circuit 142, separately coupled to the ID decoding circuit 120, the first data transmission path 151, and the second data transmission path 152, where the second data selecting circuit 142 is configured to output the other of the first data signal B1 or the second data signal B2 to the second data receiving circuit 132 according to the data selection signal.

The first data selecting circuit 141 and the second data selecting circuit 142 may output corresponding data signals according to the data selection signals. Taking the first data selecting circuit 141 as an example, the first data selecting circuit 141 includes a control terminal, a plurality of input terminals, and an output terminal. The control terminal of the first data selecting circuit 141 is configured to receive the data selection signal, the plurality of input terminals of the first data selecting circuit 141 are respectively coupled to the plurality of data transmission paths, and the output terminal of the first data selecting circuit 141 is coupled to the first data receiving circuit 131; the first data selecting circuit 141 may output the first data signal B1 (or the second data signal B2) to the first data receiving circuit 131 under the control of the data selection signal received by the control terminal.

Similarly, the second data selecting circuit 142 includes a control terminal, a plurality of input terminals, and an output terminal. The control terminal of the second data selecting circuit 142 is configured to receive the data selection signal, the plurality of input terminals of the second data selecting circuit 142 are respectively coupled to the plurality of data transmission paths, and the output terminal of the second data selecting circuit 142 is coupled to the second data receiving circuit 132; the second data selecting circuit 142 may output the second data signal B2 (or the first data signal B1) to the second data receiving circuit 132 under the control of the data selection signal received by the control terminal.

In some embodiments, the first data signal B1 and the second data signal B2 may be different row address (row address, RA) signals, for example, a row address signal RA1 and a row address signal RA2. The binary values corresponding to the row address signal RA1 and the row address signal RA2 may be the same or different, which is not particularly limited in the present disclosure. In other embodiments, the first data signal B1 and the second data signal B2 may also be signals of different types. The first data signal B1 and the second data signal B2 are respectively transmitted to different data receiving circuits in the same semiconductor chip.

It should be noted that in the embodiment, the first data selecting circuit 141 and the second data selecting circuit 142 are different data selecting circuits, and the first data selecting circuit 141 and the second data selecting circuit 142 may output data signals of different types based on the same data selection signal. For example, the first data selecting circuit 141 outputs the row address signal RA1 to the first data receiving circuit 131, and the second data selecting circuit 142 outputs the row address signal RA2 to the second data receiving circuit 132.

The first data transmission path 151 and the second data transmission path 152 may be a through silicon via (through silicon via, TSV) structure in the semiconductor chip 100.

In the embodiment of the present disclosure, through the arrangement of the first data selecting circuit and the second data selecting circuit, the first data selecting circuit may transmit the first data signal (or the second data signal) to the first data receiving circuit according to the data selection signal, and the second data selecting circuit may transmit the second data signal (or the first data signal) to the second data receiving circuit according to the data selection signal, thereby ensuring that the data is accurately transmitted to each data receiving circuit in the semiconductor chip.

In some embodiments, referring to FIG. 2, the first ID transmission path 111 includes: a first connection pad 161 located on the inactive face S2 of the semiconductor chip 100, a first path 171 located in the substrate, and a first interconnection structure 181 located on the active surface S1 of the semiconductor chip 100, where the first connection pad 161, the first path 171, and the first interconnection structure 181 are sequentially connected; the second ID transmission path 112 includes: a second connection pad 162 located on the inactive face S2 of the semiconductor chip 100, a second path 172 located in the substrate, and a second interconnection structure 182 located on the active surface S1 of the semiconductor chip 100, where the second connection pad 162, the second path 172, and the second interconnection structure 182 are sequentially connected.

In a specific embodiment, the first connection pad 161 and the second connection pad 162 may be micro bumps (uBumps) located on the inactive face S2 of the semiconductor chip 100; the first path 171 and the second path 172 may be TSV structures; the first interconnection structure 181 and the second interconnection structure 182 may be metal wirings located on the active surface S1 of the semiconductor chip 100.

It should be noted that the number of the micro bump, the number of the through silicon via structure, and the number of the metal wiring shown in FIG. 2 are exemplary to convey the present disclosure to those skilled in the art. In practical applications, the number of the micro bump, the number of the through silicon via structure, and the number of the metal wiring in the semiconductor chip are not limited thereto.

In some embodiments, the first connection pad 161 and the second connection pad 162 are symmetrically distributed based on the central axis L; the first path 171 and the second path 172 are symmetrically distributed based on the central axis L; the first interconnection structure 181 and the second interconnection structure 182 are symmetrically distributed based on the central axis L.

In some embodiments, the ID decoding circuit 120 is coupled to the first interconnection structure 181 or the second interconnection structure 182.

The materials of the first connection pad 161, the second connection pad 162, the first path 171, the second path 172, the first interconnection structure 181, and the second interconnection structure 182 include a conductive material, for example, any one of polycrystalline silicon, doped polycrystalline silicon, tantalum, titanium, tungsten, copper, titanium nitride, tantalum nitride, or tungsten nitride, or a combination thereof. The materials of any two of the first connection pad 161, the second connection pad 162, the first path 171, the second path 172, the first interconnection structure 181, and the second interconnection structure 182 may be the same or different.

In some embodiments, the first data transmission path 151 includes: a third connection pad located on the inactive face of the semiconductor chip, a third path located in the substrate, and a third interconnection structure located on the active surface of the semiconductor chip, where the third connection pad, the third path, and the third interconnection structure are sequentially connected; the second data transmission path 152 includes: a fourth connection pad located on the inactive face of the semiconductor chip, a fourth path located in the substrate, and a fourth interconnection structure located on the active surface of the semiconductor chip, where the fourth connection pad, the fourth path, and the fourth interconnection structure are sequentially connected. Here, the structures of the first data transmission path 151 and the second data transmission path 152 may refer to the first ID transmission path 111 and the second ID transmission path 112, which will not be repeated here.

In some embodiments, referring to FIG. 3, the semiconductor chip 100 further includes a first redundant path 191 and a second redundant path 192, and the first redundant path 191 and the second redundant path 192 are symmetrically distributed based on the central axis L of the semiconductor chip. The number of the first redundant path 191 and the second redundant path 192 may be one or more, and three first redundant paths 191 and three second redundant paths 192 are shown in FIG. 3.

Based on the above semiconductor chip, the embodiment of the present disclosure further provides a semiconductor structure.

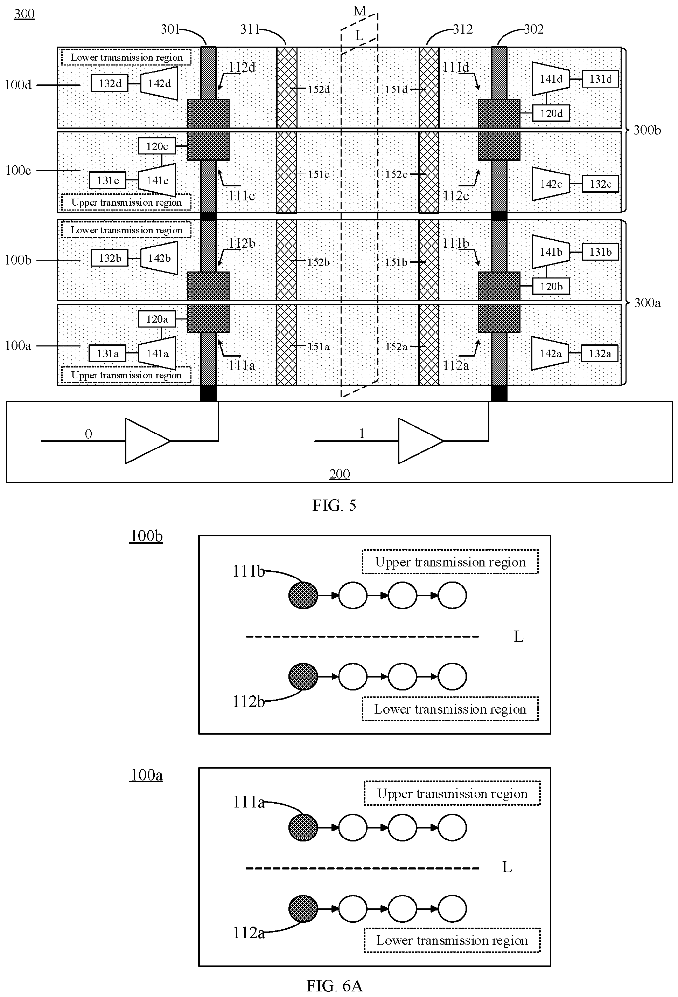

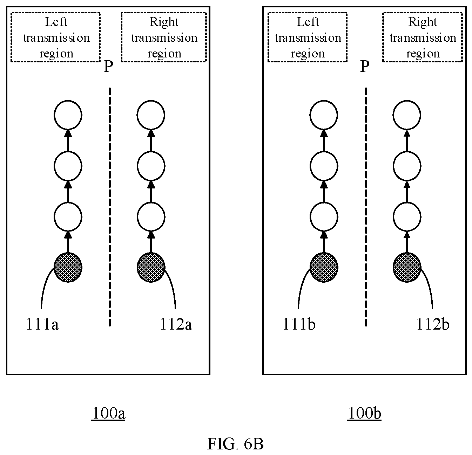

FIG. 5 is a schematic view of a semiconductor structure 300 according to an embodiment of the present disclosure, and FIGS. 6A and 6B are top views of a semiconductor chip according to an embodiment of the present disclosure. The semiconductor structure 300 provided according to an embodiment of the present disclosure will be described in detail with reference to FIGS. 5, 6A, and 6B.

Referring to FIG. 5, the semiconductor structure 300 includes: a logic chip 200 and a stack structure stacked on the logic chip. The stack structure includes: the 1st to 2N-th semiconductor chips stacked sequentially, where the 1st to 2N-th semiconductor chips are the same memory chips; the inactive face of the 1st semiconductor chip is bonded to the logic chip, and the active surface of the 2i-th semiconductor chip is bonded to the active surface of the 2i-1-th semiconductor chip; N is a positive integer, and i is a positive integer less than or equal to N.

The semiconductor chip includes: a first ID transmission path, a second ID transmission path, and an ID decoding circuit. The first ID transmission path and the second ID transmission path penetrate through the substrate of the semiconductor chip in a direction perpendicular to the active surface of the semiconductor chip and are symmetrically distributed based on the central axis of the semiconductor chip; the ID decoding circuit is coupled to the first ID transmission path or the second ID transmission path, and the ID decoding circuit is configured to receive an ID signal, which indicates that the semiconductor chip is the 2i-th semiconductor chip or the 2i-1-th semiconductor chip in the stack structure.

Here, the first ID transmission path of the 2i-1-th semiconductor chip and the second ID transmission path of the 2i-th semiconductor chip are sequentially connected to form a first ID transmission channel 301; the second ID transmission path of the 2i-1-th semiconductor chip and the first ID transmission path of the 2i-th semiconductor chip are sequentially connected to form a second ID transmission channel 302.

The semiconductor structure 300 may be a memory including a logic chip and a memory chip, e.g., a high bandwidth memory (high bandwidth memory, HBM), and the semiconductor structure 300 may also be other memories known in the art.

The logic chip 200 may be one or more processors that communicate with the memory chip to access data from the memory chip or to store data in the memory chip. The logic chip 200 includes: a graphics processing unit (GPU), a field programmable gate array (FPGA), an application specific integrated circuit (ASIC), a central processing unit (CPU), or other known electronic circuits serving as processors.

The stack structure includes a plurality of semiconductor chips stacked sequentially. For example, FIG. 5 shows four semiconductor chips, which are denoted as the 1st semiconductor chip 100a, the 2nd semiconductor chip 100b, the 3rd semiconductor chip 100c, and the 4th semiconductor chip 100d, respectively. The 1st semiconductor chip 100a, the 2nd semiconductor chip 100b, the 3rd semiconductor chip 100c, and the 4th semiconductor chip 100d are the same memory chips. Here, the 1st to 4th semiconductor chips may be explained with reference to the semiconductor chip 100 shown in FIG. 2. It should be noted that the number of the semiconductor chip in the stack structure is not limited to four shown in FIG. 5, and may also be 8, 16, or more.

The 1st semiconductor chip 100a includes a first ID transmission path 111a, a second ID transmission path 112a, and an ID decoding circuit 120a; the 2nd semiconductor chip 100b includes a first ID transmission path 111b, a second ID transmission path 112b, and an ID decoding circuit 120b; the 3rd semiconductor chip 100c includes a first ID transmission path 111c, a second ID transmission path 112c, and an ID decoding circuit 120c; the 4th semiconductor chip 100d includes a first ID transmission path 111d, a second ID transmission path 112d, and an ID decoding circuit 120d. Here, the first ID transmission paths 111a to 111d, the second ID transmission paths 112a to 112d, and the ID decoding circuits 120a to 120d may be separately explained with reference to the first ID transmission path 111, the second ID transmission path 112, and the ID decoding circuit 120 shown in FIG. 2, which will not be repeated here.

Referring to FIG. 5, the 1st semiconductor chip set 300a may be formed by bonding the active surface of the 1st semiconductor chip 100a to the active surface of the 2nd semiconductor chip 100b; the 2nd semiconductor chip set 300b may be formed by bonding the active surface of the 3rd semiconductor chip 100c to the active surface of the 4th semiconductor chip 100d; 2N semiconductor chips may form N semiconductor chip sets.

It should be noted that the number of the semiconductor chip set in the semiconductor structure may be one or more. Two semiconductor chips in a semiconductor chip set are face-to-face bonded (the active surface is bonded to the active surface); for example: the 1st semiconductor chip 100a and the 2nd semiconductor chip 100b, and the 3rd semiconductor chip 100c and the 4th semiconductor chip 100d may be bonded by hybrid bonding, such as fusion bonding, diffusion bonding, or eutectic bonding. Two adjacent semiconductor chip sets are back-to-back bonded (the inactive face is bonded to the inactive face); for example: the 2nd semiconductor chip 100b in the 1st semiconductor chip set 300a and the 3rd semiconductor chip 100c in the 2nd semiconductor chip set 300b may be connected by a micro bump (uBump). In other embodiments, two semiconductor chips in a semiconductor chip set may also be bonded by other bonding methods known in the art. Two semiconductor chips in the 1st semiconductor chip set will be described below with reference to FIGS. 6A and 6B.

FIG. 6A shows top views of the 1st semiconductor chip 100a and the 2nd semiconductor chip 100b separately. Referring to FIG. 6A, the 1st semiconductor chip 100a includes an upper transmission region located on one side of the central axis L and a lower transmission region located on the other side of the central axis L, and the 2nd semiconductor chip 100b includes an upper transmission region located on one side of the central axis L and a lower transmission region located on the other side of the central axis L. Here, the semiconductor chip may be divided into two equal-sized parts based on the central axis L; the part where the first ID transmission path 111 is located may be defined as the upper transmission region, and the part where the second ID transmission path 112 is located may be defined as the lower transmission region.

In other embodiments, the semiconductor chip may be divided into two equal-sized parts based on the central axis P; the part where the first ID transmission path 111 is located may be defined as a left transmission region, and the part where the second ID transmission path 112 is located may be defined as a right transmission region, as shown in FIG. 6B. Those skilled in the art can make a selection according to actual needs. Here, the central axis P passes through the center of the semiconductor chip and is parallel to the active surface, and the central axis P is perpendicular to and intersects with the central axis L.

After the active surface of the 1st semiconductor chip 100a is bonded to the active surface of the 2nd semiconductor chip 100b, the lower transmission region of the 2nd semiconductor chip 100b is located above the upper transmission region of the 1st semiconductor chip 100a, and the upper transmission region of the 2nd semiconductor chip 100b is located above the lower transmission region of the 1st semiconductor chip 100a, as shown in FIG. 5. That is, after the active surface of the 1st semiconductor chip 100a is bonded to the active surface of the 2nd semiconductor chip 100b, the ID decoding circuit 120a of the 1st semiconductor chip 100a and the ID decoding circuit 120b of the 2nd semiconductor chip 100b are respectively located on both sides of the symmetry plane M of the semiconductor structure 300, and the same data receiving circuit (e.g., 131a and 131b) in each semiconductor chip is separately located on both sides of the symmetry plane M, where the symmetry plane M is perpendicular to the active surface S1 (or the inactive face S2), and the central axis L is located in the symmetry plane M.

When the semiconductor structure 300 includes the 1st semiconductor chip set, the first ID transmission channel 301 includes the first ID transmission path 111a of the 1st semiconductor chip 100a and the second ID transmission path 112b of the 2nd semiconductor chip 100b; the second ID transmission channel 302 includes the second ID transmission path 112a of the 1st semiconductor chip 100a and the first ID transmission path 111b of the 2nd semiconductor chip 100b. Further, when the semiconductor structure 300 further includes a 2nd semiconductor chip set, the first ID transmission channel 301 further includes the first ID transmission path 111c of the 3rd semiconductor chip 100c and the second ID transmission path 112d of the 4th semiconductor chip 100d; the second ID transmission channel 302 further includes the second ID transmission path 112c of the 3rd semiconductor chip 100c and the first ID transmission path 111d of the 4th semiconductor chip 100d.

Here, the sequentially connected ID transmission paths located on one side of the symmetry plane M form the first ID transmission channel 301, and the sequentially connected ID transmission paths located on the other side of the symmetry plane M form the second ID transmission channel 302; the first ID transmission channel 301 and the second ID transmission channel 302 are symmetrically distributed based on the central axis L.

The first ID transmission channel 301 and the second ID transmission channel 302 are used for transmitting ID signals. For example, the first ID transmission channel 301 is configured to transmit the first ID signal, and the second ID transmission channel 302 is configured to transmit the second ID signal; the first ID signal is different from the second ID signal. The first ID signal may be represented by a binary signal "0" and the second ID signal may be represented by a binary signal "1".

In some embodiments, when the ID decoding circuit is coupled to the first ID transmission path, the ID decoding circuit 120a of the 1st semiconductor chip 100a may assign an odd flag bit to the 1st semiconductor chip 100a according to the first ID signal "0" transmitted in the first ID transmission channel 301, and the ID decoding circuit 120b of the 2nd semiconductor chip 100b may assign an even flag bit to the 2nd semiconductor chip 100b according to the second ID signal "1" transmitted in the second ID transmission channel 302. Further, the ID decoding circuit 120c of the 3rd semiconductor chip 100c may assign an odd flag bit to the 3rd semiconductor chip 100c according to the first ID signal "0" transmitted in the first ID transmission channel 301, and the ID decoding circuit 120d of the 4th semiconductor chip 100d may assign an even flag bit to the 4th semiconductor chip 100d according to the second ID signal "1" transmitted in the second ID transmission channel 302.

In some other embodiments, when the ID decoding circuit is coupled to the second ID transmission path, the ID decoding circuit 120a of the 1st semiconductor chip 100a may assign an odd flag bit to the 1st semiconductor chip 100a according to the second ID signal "1" transmitted in the second ID transmission channel 302, and the ID decoding circuit 120b of the 2nd semiconductor chip 100b may assign an even flag bit to the 2nd semiconductor chip 100b according to the first ID signal "0" transmitted in the first ID transmission channel 301. Further, the ID decoding circuit 120c of the 3rd semiconductor chip 100c may assign an odd flag bit to the 3rd semiconductor chip 100c according to the second ID signal "1" transmitted in the second ID transmission channel 302, and the ID decoding circuit 120d of the 4th semiconductor chip 100d may assign an even flag bit to the 4th semiconductor chip 100d according to the first ID signal "0" transmitted in the first ID transmission channel 301.

It will be understood that in the above two embodiments, different definitions may be assigned to the ID signal according to the position of the ID decoding circuit. For example, the ID signal "0" indicates that the semiconductor chip is a memory chip in an odd tier of the stack structure, and the ID signal "1" indicates that the semiconductor chip is a memory chip in an even tier of the stack structure; alternatively, the ID signal "0" indicates that the semiconductor chip is a memory chip in an even tier of the stack structure, and the ID signal "1" indicates that the semiconductor chip is a memory chip in an odd tier of the stack structure.

In other embodiments, fixed definitions may also be assigned to the ID signals "0" and "1", and the ID signals transmitted in the first ID transmission channel 301 and the second ID transmission channel 302 are exchanged according to the position of the ID decoding circuit, thereby ensuring that each semiconductor chip in the stack structure is assigned an odd flag bit or an even flag bit through the first ID transmission channel 301 and the second ID transmission channel 302.

It should be noted that since the same data receiving circuit (e.g., 131a and 131b) in the semiconductor chip 100a located in an odd tier and the semiconductor chip 100b located in an even tier are respectively located on both sides of the symmetry plane M, and the data signal transmitted in the data transmission channel is not switched, an odd-even ID signal is required to switch the data signal transmitted to the same data receiving circuit. According to the embodiment of the present disclosure, each semiconductor chip in the stack structure is assigned an odd flag bit or an even flag bit, and the odd flag bit or the even flag bit may serve as a switching ID of a transmission path between data and a circuit, such that the data is accurately transmitted to the corresponding data receiving circuit in each chip of the stack structure.

In the embodiment of the present disclosure, a stack structure is arranged on a logic chip; the stack structure includes the 1st to 2N-th semiconductor chips stacked sequentially, where the 1st to 2N-th semiconductor chips are the same memory chips; the first ID transmission path of the 2i-1-th semiconductor chip and the second ID transmission path of the 2i-th semiconductor chip are sequentially connected to form a first ID transmission channel, and the second ID transmission path of the 2i-1-th semiconductor chip and the first ID transmission path of the 2i-th semiconductor chip are sequentially connected to form a second ID transmission channel; through the first ID transmission channel and the second ID transmission channel, each semiconductor chip in the stack structure can be assigned an odd flag bit or an even flag bit, and the odd flag bit or the even flag bit may serve as a switching ID of a transmission path between data and a circuit, such that the data is accurately transmitted to the corresponding data receiving circuit in each chip of the stack structure.

In addition, according to the embodiment of the present disclosure, the first ID transmission path and the second ID transmission path are symmetrically distributed based on the central axis in the semiconductor chip, such that the complexity of assigning the stack ID is reduced, thereby allowing more memory chips to be three-dimensionally packaged, which is beneficial to improving the integration level of the semiconductor structure and increasing the memory capacity.

In some embodiments, referring to FIG. 5, the logic chip 200 is configured to: output the first ID signal to the ID decoding circuit of the 2i-1-th semiconductor chip through one of the first ID transmission channel 301 and the second ID transmission channel 302; and output the second ID signal to the ID decoding circuit of the 2i-th semiconductor chip through the other of the first ID transmission channel and the second ID transmission channel, where the second ID signal is different from the first ID signal.

The logic chip 200 includes an ID signal generation circuit for generating an ID signal. For example, the ID signal generation circuit includes a first sub-ID signal generation circuit for generating the first ID signal (or the second ID signal) and a second sub-ID signal generation circuit for generating the second ID signal (or the first ID signal); the first sub-ID signal generation circuit may be coupled to the first ID transmission channel 301, and the second sub-ID signal generation circuit may be coupled to the second ID transmission channel 302.

In some embodiments, when the ID decoding circuit in each chip is coupled to the first ID transmission path, the logic chip 200 separately transmits the first ID signal "0" to the ID decoding circuit 120a of the 1st semiconductor chip 100a and the ID decoding circuit 120c of the 3rd semiconductor chip 100c through the first ID transmission channel 301, and the logic chip 200 separately transmits the second ID signal "1" to the ID decoding circuit 120b of the 2nd semiconductor chip 100b and the ID decoding circuit 120d of the 4th semiconductor chip 100d through the second ID transmission channel 302.

In some other embodiments, when the ID decoding circuit in each chip is coupled to the second ID transmission path, the logic chip 200 separately transmits the second ID signal "1" to the ID decoding circuit 120a of the 1st semiconductor chip 100a and the ID decoding circuit 120c of the 3rd semiconductor chip 100c through the second ID transmission channel 302, and the logic chip 200 separately transmits the first ID signal "0" to the ID decoding circuit 120b of the 2nd semiconductor chip 100b and the ID decoding circuit 120d of the 4th semiconductor chip 100d through the first ID transmission channel 301.

It will be understood that according to the semiconductor structure provided in the embodiment of the present disclosure, different ID signals (for example, "0" and "1") may be transmitted to the ID decoding circuits of the memory chips in different tiers, respectively, and the ID decoding circuits decode the received ID signals to generate the data selection signals, such that the data is accurately transmitted to each chip of the stack structure.

In some embodiments, the ID decoding circuit is configured to: decode the first ID signal to generate a first data selection signal, or decode the second ID signal to generate a second data selection signal, where the second data selection signal is different from the first data selection signal.

In an embodiment, the ID decoding circuit in each chip is coupled to the first ID transmission path. With reference to FIG. 5, the ID decoding circuit 120a of the 1st semiconductor chip 100a receives the first ID signal "0" transmitted by the first ID transmission path 111a and decodes the first ID signal to generate the first data selection signal, for example, the first data selection signal "1"; the ID decoding circuit 120b of the 2nd semiconductor chip 100b receives the second ID signal "1" transmitted by the first ID transmission path 111b and decodes the second ID signal to generate the second data selection signal, for example, the second data selection signal "0".

In another embodiment, the ID decoding circuit in each chip is coupled to the second ID transmission path. With reference to FIG. 5, the ID decoding circuit 120a of the 1st semiconductor chip 100a receives the second ID signal "1" transmitted by the second ID transmission path 112a and decodes the second ID signal to generate the second data selection signal, for example, the second data selection signal "0"; the ID decoding circuit 120b of the 2nd semiconductor chip 100b receives the first ID signal "0" transmitted by the second ID transmission path 112b and decodes the first ID signal to generate the first data selection signal, for example, the first data selection signal "1".

In some embodiments, the semiconductor chip further includes: a first data receiving circuit, a second data receiving circuit, a first data transmission path, a second data transmission path, a first data selecting circuit, and a second data selecting circuit. The first data transmission path and the second data transmission path penetrate through the substrate in the direction perpendicular to the active surface of the semiconductor chip and are symmetrically distributed based on the central axis. The first data selecting circuit is separately coupled to the ID decoding circuit, the first data transmission path, the second data transmission path, and the first data receiving circuit; the second data selecting circuit is separately coupled to the ID decoding circuit, the first data transmission path, the second data transmission path, and the second data receiving circuit.

Here, the first data transmission path of the 2i-1-th semiconductor chip and the second data transmission path of the 2i-th semiconductor chip are sequentially connected to form a first data transmission channel 311; the second data transmission path of the 2i-1-th semiconductor chip and the first data transmission path of the 2i-th semiconductor chip are sequentially connected to form a second data transmission channel 312. The first data transmission channel 311 is configured to transmit a first data signal, the second data transmission channel 312 is configured to transmit a second data signal, and the second data signal is different from the first data signal.

Referring to FIG. 5, the 1st semiconductor chip 100a includes a first data receiving circuit 131a, a second data receiving circuit 132a, a first data transmission path 151a, a second data transmission path 152a, a first data selecting circuit 141a, and a second data selecting circuit 142a; the 2nd semiconductor chip 100b includes a first data receiving circuit 131b, a second data receiving circuit 132b, a first data transmission path 151b, a second data transmission path 152b, a first data selecting circuit 141b, and a second data selecting circuit 142b; the 3rd semiconductor chip 100c includes a first data receiving circuit 131c, a second data receiving circuit 132c, a first data transmission path 151c, a second data transmission path 152c, a first data selecting circuit 141c, and a second data selecting circuit 142c; the 4th semiconductor chip 100d includes a first data receiving circuit 131d, a second data receiving circuit 132d, a first data transmission path 151d, a second data transmission path 152d, a first data selecting circuit 141d, and a second data selecting circuit 142d.

The first data receiving circuits 131a to 131d, the second data receiving circuits 132a to 132d, the first data transmission paths 151a to 151d, the second data transmission paths 152a to 152d, the first data selecting circuits 141a to 141d, and the second data selecting circuits 142a to 142d can be explained separately with reference to the first data receiving circuit 131, the second data receiving circuit 132, the first data transmission path 151, the second data transmission path 152, the first data selecting circuit 141, and the second data selecting circuit 142 shown in FIGS. 2 and 4, which will not be repeated here.

The first data transmission channel 311 includes the first data transmission path 151a of the 1st semiconductor chip 100a, the second data transmission path 152b of the 2nd semiconductor chip 100b, the first data transmission path 151c of the 3rd semiconductor chip 100c, and the second data transmission path 152d of the 4th semiconductor chip 100d; the second data transmission channel 312 includes the second data transmission path 152a of the 1st semiconductor chip 100a, the first data transmission path 151b of the 2nd semiconductor chip 100b, the second data transmission path 152c of the 3rd semiconductor chip 100c, and the first data transmission path 151d of the 4th semiconductor chip 100d.

It will be understood that the sequentially connected data transmission paths located on one side of the symmetry plane M form the first data transmission channel 311, and the sequentially connected data transmission paths located on the other side of the symmetry plane M form the second data transmission channel 312; the first data transmission channel 311 and the second data transmission channel 312 are symmetrically distributed based on the central axis L.

The first data transmission channel 311 and the second data transmission channel 312 are used for transmitting data signals. For example, the first data transmission channel is configured to transmit a first data signal B1, and the second data transmission channel is configured to transmit a second data signal B2.

In some embodiments, the first data selecting circuit of the 2i-1-th semiconductor chip is configured to: output one of the first data signal and the second data signal to the first data receiving circuit of the 2i-1-th semiconductor chip according to the first data selection signal.

The second data selecting circuit of the 2i-1-th semiconductor chip is configured to: output the other of the first data signal and the second data signal to the second data receiving circuit of the 2i-1-th semiconductor chip according to the first data selection signal.

The first data selecting circuit of the 2i-th semiconductor chip is configured to: output one of the first data signal and the second data signal to the first data receiving circuit of the 2i-th semiconductor chip according to the second data selection signal.

The second data selecting circuit of the 2i-th semiconductor chip is configured to: output the other of the first data signal and the second data signal to the second data receiving circuit of the 2i-th semiconductor chip according to the second data selection signal.

The first data selecting circuit 141a of the 1st semiconductor chip 100a may output the first data signal B1 to the first data receiving circuit 131a of the 1st semiconductor chip 100a according to the first data selection signal; the second data selecting circuit 142a of the 1st semiconductor chip 100a may output the second data signal B2 to the second data receiving circuit 132a of the 1st semiconductor chip 100a according to the first data selection signal.

The first data selecting circuit 141b of the 2nd semiconductor chip 100b may output the first data signal B1 to the first data receiving circuit 131b of the 2nd semiconductor chip 100b according to the second data selection signal; the second data selecting circuit 142b of the 2nd semiconductor chip 100b may output the second data signal B2 to the second data receiving circuit 132b of the 2nd semiconductor chip 100b according to the second data selection signal.

The first data selecting circuit 141c of the 3rd semiconductor chip 100c may output the first data signal B1 to the first data receiving circuit 131c of the 3rd semiconductor chip 100c according to the first data selection signal; the second data selecting circuit 142c of the 3rd semiconductor chip 100c may output the second data signal B2 to the second data receiving circuit 132c of the 3rd semiconductor chip 100c according to the first data selection signal.

The first data selecting circuit 141d of the 4th semiconductor chip 100d may output the first data signal B1 to the first data receiving circuit 131d of the 4th semiconductor chip 100d according to the second data selection signal; the second data selecting circuit 142d of the 4th semiconductor chip 100d may output the second data signal B2 to the second data receiving circuit 132d of the 4th semiconductor chip 100d according to the second data selection signal.

It should be noted that when the 1st semiconductor chip 100a, the 2nd semiconductor chip 100b, the 3rd semiconductor chip 100c, and the 4th semiconductor chip 100d are not separately assigned an odd flag bit and an even flag bit, the first data receiving circuit of the semiconductor chip located in an odd tier receives the first data signal B1, and the second data receiving circuit of the semiconductor chip located in an odd tier receives the second data signal B2; however, the first data receiving circuit of the semiconductor chip located in an even tier receives the second data signal B2, and the second data receiving circuit of the semiconductor chip located in an odd tier receives the first data signal B1, such that the first data signal B1 and the second data signal B2 cannot be accurately transmitted to the corresponding internal receiving circuits.

According to the semiconductor structure provided in the embodiment of the present disclosure, each semiconductor chip in the stack structure is separately assigned an odd flag bit or an even flag bit, and the odd flag bit or the even flag bit may serve as a switching ID of a transmission path between data and a circuit, such that the data is accurately transmitted to the corresponding internal receiving circuit in each semiconductor chip of the stack structure.

In some embodiments, the central axes of any two adjacent semiconductor chips among the 1st to 2N-th semiconductor chips are aligned, where the first ID transmission path of one of the two adjacent semiconductor chips is aligned with the second ID transmission path of the other of the two adjacent semiconductor chips.

Referring to FIG. 5, the central axes L of the 1st semiconductor chip 100a, the 2nd semiconductor chip 100b, the 3rd semiconductor chip 100c, and the 4th semiconductor chip 100d are all aligned and coincide.

The first ID transmission path 111a of the 1st semiconductor chip 100a and the second ID transmission path 112b of the 2nd semiconductor chip 100b are aligned, and the second ID transmission path 112a of the 1st semiconductor chip 100a and the first ID transmission path 111b of the 2nd semiconductor chip 100b are aligned. In a specific embodiment, the first interconnection structure of the 1st semiconductor chip 100a and the second interconnection structure of the 2nd semiconductor chip 100b are aligned, and the second interconnection structure of the 1st semiconductor chip 100a and the first interconnection structure of the 2nd semiconductor chip 100b are aligned.

The second ID transmission path 112b of the 2nd semiconductor chip 100b and the first ID transmission path 111c of the 3rd semiconductor chip 100c are aligned, and the first ID transmission path 111b of the 2nd semiconductor chip 100b and the second ID transmission path 112c of the 3rd semiconductor chip 100c are aligned. In a specific embodiment, the second connection pad of the 2nd semiconductor chip 100b and the first connection pad of the 3rd semiconductor chip 100c are aligned, and the first connection pad of the 2nd semiconductor chip 100b and the second connection pad of the 3rd semiconductor chip 100c are aligned.

In some embodiments, the inactive face of the 2j-th semiconductor chip is bonded to the inactive face of the 2j+1-th semiconductor chip, where j is an integer greater than or equal to one, and 2j+1 is less than 2N. For example, as shown in FIG. 5, the inactive face of the 2nd semiconductor chip 100b is bonded to the inactive face of the 3rd semiconductor chip 100c, e.g., being bonded through the connection pad on the inactive face of the semiconductor chip.

In some embodiments, the first ID transmission path includes: a first connection pad located on the inactive face of the semiconductor chip, a first path located in the substrate, and a first interconnection structure located on the active surface of the semiconductor chip, where the first connection pad, the first path, and the first interconnection structure are sequentially connected. The second ID transmission path includes: a second connection pad located on the inactive face of the semiconductor chip, a second path located in the substrate, and a second interconnection structure located on the active surface of the semiconductor chip, where the second connection pad, the second path, and the second interconnection structure are sequentially connected. The first ID transmission path and the second ID transmission path may refer to the first ID transmission path 111 and the second ID transmission path 112 in FIG. 2, respectively, which will not be repeated here.

Based on the above semiconductor chip or semiconductor structure, an embodiment of the present disclosure further provides a semiconductor device, including:
a substrate.

The semiconductor chip 100 according to any one of the above embodiments is located on the substrate, and the semiconductor chip 100 is bonded to the substrate. Alternatively, the semiconductor structure 300 according to any one of the above embodiments is located on the substrate, and the semiconductor structure 300 is bonded to the substrate.

The substrate includes a package substrate for bearing a logic chip and a memory chip, for example, a low temperature co-fired ceramic substrate or a printed circuit board.

In some embodiments, the semiconductor device includes: a high bandwidth memory.

The above description is only the specific embodiments of the present disclosure, but the protection scope of the present disclosure is not limited thereto; changes or substitutions that any of those skilled in the art can easily think of within the technical scope disclosed by the present disclosure shall all fall within the protection scope of the present disclosure. Therefore, the protection scope of the present disclosure shall be defined by the protection scope of the claims.

## Claims

1. A semiconductor chip (100), comprising:
a first identification (ID) transmission path (111), penetrating through a substrate of the semiconductor chip (100) in a direction perpendicular to an active surface (S1) of the semiconductor chip (100);
a second ID transmission path (112), penetrating through the substrate in the direction perpendicular to the active surface (S1) of the semiconductor chip (100), and symmetrically distributed with the first ID transmission path (111) based on a central axis of the semiconductor chip (100), wherein the central axis passes through a center of the semiconductor chip (100) and is parallel to the active surface (S1); and
an ID decoding circuit (120), coupled to the first ID transmission path (111) or the second ID transmission path (112), wherein the ID decoding circuit (120) is configured to receive an ID signal and decode the ID signal to generate a data selection signal,
wherein the semiconductor chip (100) outputs data signals transmitted in a plurality of data transmission paths to corresponding internal receiving circuits respectively according to the data selection signal.

2. The semiconductor chip (100) according to claim 1, wherein each of the internal receiving circuits comprises: a first data receiving circuit (131) and a second data receiving circuit (132), wherein the first data receiving circuit (131) is coupled to a first data selecting circuit (141), and the second data receiving circuit (132) is coupled to a second data selecting circuit (142);
and the plurality of data transmission paths comprise:
a first data transmission path (151), penetrating through the substrate in the direction perpendicular to the active surface (S1) of the semiconductor chip (100), wherein the first data transmission path (151) is configured to transmit a first data signal;
a second data transmission path (152), penetrating through the substrate in the direction perpendicular to the active surface (S1) of the semiconductor chip (100), and symmetrically distributed with the first data transmission path (151) based on the central axis, wherein the second data transmission path (152) is configured to transmit a second data signal, and the second data signal is different from the first data signal;
the first data selecting circuit (141), separately coupled to the ID decoding circuit (120), the first data transmission path (151), and the second data transmission path (152), wherein the first data selecting circuit (141) is configured to output one of the first data signal or the second data signal to the first data receiving circuit (131) according to the data selection signal; and
the second data selecting circuit (142), separately coupled to the ID decoding circuit (120), the first data transmission path (151), and the second data transmission path (152), wherein the second data selecting circuit (142) is configured to output the other of the first data signal or the second data signal to the second data receiving circuit (132) according to the data selection signal.

3. The semiconductor chip (100) according to claim 1 or 2, wherein
the first ID transmission path (111) is configured to transmit a first ID signal; and
the second ID transmission path (112) is configured to transmit a second ID signal, wherein the second ID signal is different from the first ID signal.

4. The semiconductor chip (100) according to any one of claims 1 to 3, wherein
the first ID transmission path (111) comprises: a first connection pad (161) located on an inactive face (S2) of the semiconductor chip (100), a first path (171) located in the substrate, and a first interconnection structure (181) located on the active surface (S1) of the semiconductor chip (100), wherein the first connection pad (161), the first path (171), and the first interconnection structure (181) are sequentially connected; and
the second ID transmission path (112) comprises: a second connection pad (162) located on the inactive face (S2) of the semiconductor chip (100), a second path (172) located in the substrate, and a second interconnection structure (182) located on the active surface (S1) of the semiconductor chip (100), wherein the second connection pad (162), the second path (172), and the second interconnection structure (182) are sequentially connected.

5. The semiconductor chip (100) according to claim 4, wherein the ID decoding circuit (120) is coupled to the first interconnection structure (181) or the second interconnection structure (182).

6. A semiconductor structure (300), comprising:
a logic chip (200); and
a stack structure, stacked on the logic chip (200), and comprising: 1st to 2N-th semiconductor chips (100a, 100b, 100c, 100d) stacked sequentially, wherein the 1st to 2N-th semiconductor chips (100a, 100b, 100c, 100d) are same memory chips; an inactive face (S2) of the 1st semiconductor chip (100a) is bonded to the logic chip (200), and an active surface (S1) of a 2i-th semiconductor chip (100b, 100d) is bonded to an active surface (S1) of a 2i-1-th semiconductor chip (100a, 100c); and N is a positive integer, and i is a positive integer less than or equal to N; and wherein
each of the semiconductor chips (100a, 100b, 100c, 100d) comprises: a first ID transmission path (111a, 111b, 111c, 111d), a second ID transmission path (112a, 112b, 112c, 112d), and an ID decoding circuit (120a, 120b, 120c, 120d); the first ID transmission path (111a, 111b, 111c, 111d) and the second ID transmission path (112a, 112b, 112c, 112d) penetrate through a substrate of one of the semiconductor chips (100a, 100b, 100c, 100d) in a direction perpendicular to an active surface (S1) of the corresponding one of the semiconductor chips (100a, 100b, 100c, 100d) and are symmetrically distributed based on a central axis of the corresponding one of the semiconductor chips (100a, 100b, 100c, 100d), and the central axis passes through a center of the corresponding one of the semiconductor chips (100a, 100b, 100c, 100d) and is parallel to the active surface (S1); and the ID decoding circuit (120a, 120b, 120c, 120d) is coupled to the first ID transmission path (111a, 111b, 111c, 111d) or the second ID transmission path (112a, 112b, 112c, 112d), the ID decoding circuit (120a, 120b, 120c, 120d) is configured to receive an ID signal, and the ID signal indicates that one of the semiconductor chips (100a, 100b, 100c, 100d) is the 2i-th semiconductor chip (100b, 100d) or the 2i-1-th semiconductor chip (100a, 100c) in the stack structure,
wherein the first ID transmission path (111a, 111c) of the 2i-1-th semiconductor chip (100a, 100c) and the second ID transmission path (112b, 112d) of the 2i-th semiconductor chip (100b, 100d) are sequentially connected to form a first ID transmission channel; and the second ID transmission path (112a, 112c) of the 2i-1-th semiconductor chip (100a, 100c) and the first ID transmission path (111b, 111d) of the 2i-th semiconductor chip (100b, 100d) are sequentially connected to form a second ID transmission channel.

7. The semiconductor structure (300) according to claim 6, wherein the logic chip (200) is configured to:
output a first ID signal to the ID decoding circuit (120a, 120c) of the 2i-1-th semiconductor chip (100a, 100c) through one of the first ID transmission channel and the second ID transmission channel; and
output a second ID signal to the ID decoding circuit (120b, 120d) of the 2i-th semiconductor chip (100b, 100d) through the other of the first ID transmission channel and the second ID transmission channel, wherein the second ID signal is different from the first ID signal.

8. The semiconductor structure according to claim 7, wherein the ID decoding circuit (120a, 120b, 120c, 120d) is configured to: decode the first ID signal to generate a first data selection signal, or decode the second ID signal to generate a second data selection signal,
wherein the second data selection signal is different from the first data selection signal.

9. The semiconductor structure (300) according to claim 7 or 8, wherein each of the semiconductor chips (100a, 100b, 100c, 100d) further comprises: a first data receiving circuit (131a, 131b, 131c, 131d), a second data receiving circuit (132a, 132b, 132c, 132d), a first data transmission path (151a, 151b, 151c, 151d), a second data transmission path (152a, 152b, 152c, 152d), a first data selecting circuit (141a, 141b, 141c, 141d), and a second data selecting circuit (142a, 142b, 142c, 142d), wherein the first data transmission path (151a, 151b, 151c, 151d) and the second data transmission path (152a, 152b, 152c, 152d) penetrate through the substrate in a direction perpendicular to an active surface (S1) of one of the semiconductor chips (100a, 100b, 100c, 100d) and are symmetrically distributed based on the central axis;
the first data selecting circuit (141a, 141b, 141c, 141d) is separately coupled to the ID decoding circuit (120a, 120b, 120c, 120d), the first data transmission path (151a, 151b, 151c, 151d), the second data transmission path (152a, 152b, 152c, 152d), and the first data receiving circuit (131a, 131b, 131c, 131d); and
the second data selecting circuit (142a, 142b, 142c, 142d) is separately coupled to the ID decoding circuit (120a, 120b, 120c, 120d), the first data transmission path (151a, 151b, 151c, 151d), the second data transmission path (152a, 152b, 152c, 152d), and the second data receiving circuit (132a, 132b, 132c, 132d); and
wherein the first data transmission path (151a, 151c) of the 2i-1-th semiconductor chip (100a, 100c) and the second data transmission path (152b, 152d) of the 2i-th semiconductor chip (100b, 100d) are sequentially connected to form a first data transmission channel (311); the second data transmission path (152a, 152c) of the 2i-1-th semiconductor chip (100a, 100c) and the first data transmission path (151b, 151d) of the 2i-th semiconductor chip (100b, 100d) are sequentially connected to form a second data transmission channel (312); the first data transmission channel (311) is configured to transmit a first data signal; the second data transmission channel (312) is configured to transmit a second data signal; and the second data signal is different from the first data signal.

10. The semiconductor structure (300) according to claim 9, wherein
the first data selecting circuit (141a, 141c) of the 2i-1-th semiconductor chip (100a, 100c) is configured to: output one of the first data signal and the second data signal to the first data receiving circuit (131a, 131c) of the 2i-1-th semiconductor chip (100a, 100c) according to the first data selection signal;
the second data selecting circuit (142a, 142c) of the 2i-1-th semiconductor chip (100a, 100c) is configured to: output the other of the first data signal and the second data signal to the second data receiving circuit (132a, 132c) of the 2i-1-th semiconductor chip (100a, 100c) according to the first data selection signal;
the first data selecting circuit (141b, 141d) of the 2i-th semiconductor chip (100b, 100d) is configured to: output one of the first data signal and the second data signal to the first data receiving circuit (131b, 131d) of the 2i-th semiconductor chip (100b, 100d) according to the second data selection signal; and
the second data selecting circuit (142b, 142d) of the 2i-th semiconductor chip (100b, 100d) is configured to: output the other of the first data signal and the second data signal to the second data receiving circuit (132b, 132d) of the 2i-th semiconductor chip (100b, 100d) according to the second data selection signal.

11. The semiconductor structure (300) according to any one of claims 6 to 10, wherein central axes of any two adjacent semiconductor chips (100a, 100b, 100c, 100d) among the 1st to 2N-th semiconductor chips (100a, 100b, 100c, 100d) are aligned, wherein the first ID transmission path (111a, 111b, 111c, 111d) of one of the two adjacent semiconductor chips (100a, 100b, 100c, 100d) is aligned with the second ID transmission path (112a, 112b, 112c, 112d) of the other of the two adjacent semiconductor chips (100a, 100b, 100c, 100d).

12. The semiconductor structure (300) according to any one of claims 6 to 11, wherein an inactive face (S2) of a 2j-th semiconductor chip (100b, 100d) is bonded to an inactive face (S2) of a 2j+1-th semiconductor chip (100c), wherein j is an integer greater than or equal to one, and 2j+1 is less than 2N.

13. The semiconductor structure (300) according to any one of claims 6 to 12, wherein
the first ID transmission path (111a, 111b, 111c, 111d) comprises: a first connection pad (161) located on an inactive face (S2) of one of the semiconductor chips (100a, 100b, 100c, 100d), a first path (171) located in the substrate, and a first interconnection structure (181) located on an active surface (S1) of the corresponding one of the semiconductor chips (100a, 100b, 100c, 100d), wherein the first connection pad (161), the first path (171), and the first interconnection structure (181) are sequentially connected; and
the second ID transmission path (112a, 112b, 112c, 112d) comprises: a second connection pad (162) located on an inactive face (S2) of one of the semiconductor chips (100a, 100b, 100c, 100d), a second path (172) located in the substrate, and a second interconnection structure (182) located on an active surface (S1) of the corresponding one of the semiconductor chips (100a, 100b, 100c, 100d), wherein the second connection pad (162), the second path (172), and the second interconnection structure (182) are sequentially connected.

14. A semiconductor device, comprising:
a substrate,
wherein the semiconductor chip (100) according to any one of claims 1 to 5 is located on the substrate, and the semiconductor chip (100) is bonded to the substrate; or, the semiconductor structure (300) according to any one of claims 6 to 13 is located on the substrate, and the semiconductor structure (300) is bonded to the substrate.

15. The semiconductor device according to claim 14, comprising: a high bandwidth memory.
